# EUROPÄISCHE PATENTSCHRIFT

(11) **EP 3 041 326 B1**
(45) Veröffentlichungstag und Bekanntmachung des Hinweises auf die Patenterteilung: **26.08.2020**
(21) Anmeldenummer: 15003443.7
(22) Anmeldetag: 03.12.2015
(51) Int. Cl.: H05K 3/28, B29C 64/106

(54) **VERFAHREN ZUM HERSTELLEN EINER HOCHSPANNUNGSISOLIERUNG VON ELEKTRISCHEN KOMPONENTEN**
METHOD FOR PRODUCING A HIGH VOLTAGE INSULATION OF ELECTRIC COMPONENTS
PROCEDE DE FABRICATION D'UNE ISOLATION HAUTE TENSION DE COMPOSANTS ELECTRIQUES

(30) Priorität: 12.12.2014 DE 102014018277
(43) Veröffentlichungstag der Anmeldung: 06.07.2016
(73) Patentinhaber: Tesat Spacecom GmbH & Co. KG, 71522 Backnang (DE)
(72) Erfinder: Katz, Hanspeter, 70374 Stuttgart (DE); Blass, Andreas, 74199 Untergruppenbach (DE)
(74) Vertreter: LKGLOBAL Lorenz & Kopf PartG mbB Patentanwälte

(56) Entgegenhaltungen:
- WO-A2-2008/102266
- US-A- 5 160 374
- US-A1- 2006 152 913
- US-B1- 6 573 124
- Anonymous: "Conformal coating - Wikipedia, the free encyclopedia", , 16. Oktober 2014 (2014-10-16), XP055275994, Gefunden im Internet: URL:https://en.wikipedia.org/w/index.php?t itle=Conformal_coating&oldid=629843502 [gefunden am 2016-05-27]

## Beschreibung

### Gebiet der Erfindung

Die Erfindung betrifft ein Verfahren zum Herstellen einer Hochspannungsisolierung, insbesondere zum Herstellen einer Hochspannungsisolierung für elektrische Komponenten, welche im Vakuum eingesetzt werden.

### Hintergrund der Erfindung

Elektrische Komponenten, welche beispielsweise in Satelliten verwendet werden, werden für die Zwecke eines Testvorgangs auf der Erde und für den Transport von der Erde in eine Erdumlaufbahn mit einer elektrischen Isolierung versehen. Insbesondere unter Hochspannung betriebene Schaltungsteile für Raumfahrtgeräte werden üblicherweise komplett mit einem Isoliermaterial vergossen, um sie bei Betrieb auf der Erde, d.h. innerhalb der auf der Erde herrschenden Atmosphäre, berührungssicher und bei Betrieb im Vakuum, d.h. in einer Erdumlaufbahn bzw. im Orbit, und während des Transfers dorthin überschlagsfest zu machen.

Bei einem solchen Verguss der elektrischen Komponenten wird üblicherweise ein Komplettverguss einer Baugruppe vorgenommen. Dabei wird die Baugruppe in einer Vergussform angeordnet und ein üblicherweise flüssiges Isoliermaterial wird in die Vergussform eingefüllt und aushärten lassen, um so die Baugruppe vollständig mit Isoliermaterial zu ummanteln.

US 6,573,124 B1 beschreibt eine Leiterplatte mit einer elektronischen Komponente, welche von einer Beschichtung umgeben ist.

WO 2008/102266 A2 beschreibt Verfahren zum Herstellen von Leiterplatten und zum Anbringen von Isoliermaterial auf die Leiterplatten.

US5160374A offenbart eine Hochspannungsisolierung für elektrische Komponenten zum Gebrauch in Weltraumfahrzeugen, wobei manche Bereiche lediglich von einer Isolierschicht, andere von zwei Isolierschichten bedeckt sind.

### Zusammenfassung der Erfindung

Es kann als Aufgabe der Erfindung betrachtet werden, das Herstellen einer Hochspannungsisolierung zu vereinfachen und insbesondere die Menge des benötigten Isoliermaterials für das Herstellen einer Hochspannungsisolierung von Bauteilen zur Verwendung in der Erdumlaufbahn zu reduzieren.

Diese Aufgabe wird gelöst durch den Gegenstand mit den Merkmalen des unabhängigen Anspruchs. Weiterbildungen der Erfindung ergeben sich aus den abhängigen Ansprüchen und aus der folgenden Beschreibung.

Gemäß einem Aspekt der Erfindung ist ein Verfahren zum Herstellen einer Hochspannungsisolierung von elektrischen Komponenten angegeben. Das Verfahren weist die folgenden Schritte auf: Auftragen einer ersten Schicht Isoliermaterial auf die elektrische Komponente und Auftragen einer zweiten Schicht Isoliermaterial auf die elektrische Komponente, wobei die zweite Schicht zumindest abschnittsweise auf die erste Schicht aufgetragen wird, so dass die erste Schicht zumindest abschnittsweise zwischen der zweiten Schicht und der elektrischen Komponente angeordnet ist. Erfindungsgemäß erfolgt das Auftragen des Isoliermaterials auf die elektrische Komponente mittels eines 3D-Druckverfahrens. Das Verfahren weist weiterhin die Schritte auf: Anbringen einer Mehrzahl von übereinanderliegenden Schichten Isoliermaterial in Form eines geschlossenen Polygonzugs bestehend aus einem ersten Isoliermaterial auf der elektrischen Komponente, so dass der geschlossene Polygonzug einen Teil einer Oberfläche der elektrischen Komponente und ein hierauf angeordnetes elektrisches Bauelement umschließt; und Applizieren eines zweiten Isoliermaterials auf die von dem geschlossenen Polygonzug umschlossene Oberfläche der elektrischen Komponente.

Bei der elektrischen Komponente kann es sich um eine elektrische Baugruppe mit einer Leiterplatte und/oder einer Mehrzahl von Bauelementen handeln. Die Bauelemente sind auf der Leiterplatte angeordnet oder frei verdrahtet. Die Leiterplatte ist üblicherweise ein flächiges, ebenes Element.

Dass die zweite Schicht zumindest abschnittsweise auf die erste Schicht aufgetragen wird, bedeutet, dass die erste Schicht und die zweite Schicht sich zumindest abschnittsweise überlappen. Die erste Schicht und die zweite Schicht werden auf eine Oberfläche der elektrischen Komponente, insbesondere auf die Leiterplatte und die Bauelemente aufgetragen. Dabei wird die zweite Schicht in einer Richtung senkrecht zu der Ebene der Leiterplatte über der ersten Schicht aufgetragen, überlappt diese also zumindest abschnittsweise.

Indem das Isoliermaterial schichtweise aufgetragen wird, kann die Menge des Isoliermaterials über jedem einzelnen Punkt der Oberfläche der Leiterplatte oder eines elektrischen Bauelements bestimmt werden. Eine Schicht Isoliermaterial kann sich insbesondere lediglich über einen Teil einer Oberfläche der elektrischen Komponente, d.h. der Leiterplatte oder eines Bauelements, erstrecken und muss sich nicht zwingend über eine gesamte Oberfläche erstrecken. Als Isoliermaterial kann z.B. Gießharz oder jedes andere hochspannungstaugliche Isoliermaterial verwendet werden, z.B. Solithane.

Dieses Verfahren ermöglicht damit das bedarfsgerechte elektrische Isolieren von elektrischen Bauelementen auf der elektrischen Komponente und gleichzeitig das Reduzieren der Menge des benötigten Isoliermaterials. Im Vergleich zu dem Komplettverguss, bei dem im Wesentlichen ein Block von Isoliermaterial um die elektrische Komponente unabhängig von der Platzierung der Bauelemente bereitgestellt wird, ermöglicht das hierin beschriebene Verfahren das Anbringen von Isoliermaterial nach Bedarf, d.h. insbesondere um und über elektrischen Bauelementen. Die Schichten des Isoliermaterials können sich in beliebigen Formen entlang der Oberfläche der elektrischen Komponente erstrecken.

Das Verfahren zeichnet sich insbesondere dadurch aus, dass die hiermit elektrisch isolierten Komponenten ein deutlich geringeres Gewicht aufweisen, dass eine thermomechanische Belastung der elektrischen Komponente und der verwendeten Bauelemente reduziert wird, dass Vergussformen nicht mehr nötig sind und dass mit dem Verfahren grundsätzlich beliebig geformte Isolierungen möglich sind.

Die Schichten des Isoliermaterials werden mit einem sog. 3D-Drucker auf die elektrische Komponente aufgetragen. Beim 3D-Druck wird ein Körper mit einer Erstreckung in drei Raumrichtungen produziert, indem der Körper schichtweise aufgebaut wird und eine Schicht über die andere aufgetragen wird. Indem die laterale Ausdehnung des Materials der Schichten verändert wird, kann ein dreidimensionaler Körper von nahezu beliebiger Form erzeugt werden.

Das hierin beschriebene Verfahren ermöglicht insbesondere dass die zweite Schicht einen lateralen Versatz mit Bezug zu der ersten Schicht aufweist bzw. dass die zweite Schicht eine von der ersten Schicht abweichende laterale Ausdehnung aufweist. Die laterale Ausdehnung entspricht der flächigen Ausbreitung einer Schicht entlang einer Oberfläche der elektrischen Komponente.

Das Verfahren sieht vor, dass die elektrische Komponente mit einem solchen sog. 3D-Drucker mit Isoliermaterial bedruckt wird, d.h. dass das Isoliermaterial auf eine Oberfläche der elektrischen Komponente appliziert, insbesondere aufgesprüht oder allgemein aufgetragen wird. Dazu kann die elektrische Komponente in einem Arbeitsbereich des 3D-Druckers angeordnet werden, damit die zu isolierenden Stellen von einer Düse des 3D-Druckers erreicht werden können.

Gemäß einer Ausführungsform der Erfindung weist das hierin beschriebene Verfahren weiterhin den folgenden Schritt auf: Auftragen einer n-ten Schicht Isoliermaterial auf die elektrische Komponente, wobei die n-te Schicht zumindest abschnittsweise auf die (n-1)-te Schicht aufgetragen wird.

Dies bedeutet, dass das Verfahren grundsätzlich vorsehen kann, dass eine beliebige Anzahl von Schichten zumindest abschnittsweise einander überlappend übereinander aufgetragen werden kann. Eine Schicht n wird dabei auf die unmittelbar vor ihr aufgetragene Schicht n-1 aufgetragen und die Schichten sind in einer Richtung senkrecht zu einer Oberfläche der elektrischen Komponente übereinander angeordnet.

Durch diesen Schritt bzw. diese Vielzahl von nacheinander ausführbaren Schritten zum Auftragen einer Mehrzahl von Schichten Isoliermaterial auf die elektrische Komponente ist es möglich, das Isoliermaterial in beliebigen lateralen Konturen (d.h. an welchen Stellen entlang der Oberfläche der elektrischen Komponente wird Isoliermaterial aufgetragen) in beliebiger Dicke (wie viele Schichten werden übereinander aufgetragen) auf die elektrische Komponente aufzubringen. Bei der Festlegung der Anzahl der Schichten kann eine Spannungsbelastung in einem Bereich der elektrischen Komponente berücksichtigt werden und die Anzahl der Schichten entsprechend festgelegt werden.

Gemäß einer weiteren Ausführungsform der Erfindung wird der Schritt des Auftragens einer n-ten Schicht Isoliermaterial auf die (n-1)-te Schicht Isoliermaterial so oft wiederholt, bis eine vorbestimmte Isoliermaterialdicke auf der elektrischen Komponente erreicht wird.

Die gewünschte Isoliermaterialdicke kann zwischen 1/10 Millimeter und mehrere Millimeter betragen, z.B. zwischen 6 und 12 mm. Das Isoliermaterial kann beispielsweise in Schichten von jeweils wenigen Zehntel mm bis zu 1 mm Dicke aufgetragen werden. Mit dem Verfahren wie hierin beschrieben kann insbesondere die Höhe des Isoliermaterials auf der elektrischen Komponente an deren Höhenkontur angepasst werden, um so nur die an einer Stelle der elektrischen Komponente geforderte Menge von Isoliermaterial aufzubringen. Auf benachbarten Bauelementen kann die Isoliermaterialdicke unterschiedlich sein und an die lokalen Anforderungen (d.h. an die Anforderungen an einem Punkt oder einem flächigen Abschnitt der Oberfläche der elektrischen Komponente) angepasst werden.

Gemäß einer weiteren Ausführungsform der Erfindung weist der Schritt des Auftragens der ersten Schicht Isoliermaterial auf die elektrische Komponente den folgenden Teilschritt auf: Applizieren des Isoliermaterials im flüssigen Aggregatzustand auf eine Oberfläche der elektrischen Komponente.

Das Isoliermaterial wird in diesem Verfahrensschritt auf die Oberfläche der elektrischen Komponente gesprüht oder darauf aufgetragen.

Gemäß einer weiteren Ausführungsform der Erfindung wird nach dem Applizieren des Isoliermaterials der ersten Schicht die zweite Schicht erst aufgetragen, wenn das Isoliermaterial der ersten Schicht zumindest teilweise ausgehärtet ist.

Gemäß einer weiteren Ausführungsform der Erfindung weist das Verfahren weiterhin die folgenden Schritte auf: Anbringen eines ersten Isolationsabschnitts auf der elektrischen Komponente und Anbringen eines zweiten Isolationsabschnitts auf der elektrischen Komponente, wobei der erste Isolationsabschnitt entlang einer Oberfläche der elektrischen Komponente von dem zweiten Isolationsabschnitt beabstandet ist.

Diese Verfahrensschritte ermöglichen es, die Menge des Isoliermaterials zu reduzieren und das Gewicht der isolierten elektrischen Komponenten zu reduzieren. Die beiden Isolationsabschnitte werden entweder nacheinander oder zeitgleich schichtweise erstellt, so wie oben für das Verfahren zum Herstellen der Hochspannungsisolierung beschrieben. Die Isolationsabschnitte können als voneinander getrennte und beabstandete, sich nicht überlappende Isolationen betrachtet werden, welche jeweils einem elektrischen Bauelement zugeordnet sind. In anderen Worten bilden die Isolationsabschnitte sog. Isoliermaterialinseln auf der elektrischen Komponente.

Durch diesen Aufbau kann der Hochspannungsisolierung kann das Gewicht noch weiter reduziert werden. Insbesondere ermöglicht dieser Aufbau, dass im Vakuum eine Vakuumisolierung zwischen den beiden Isolationsabschnitten bereitgestellt wird.

Gemäß einer weiteren Ausführungsform der Erfindung weist das Verfahren weiterhin den folgenden Schritt auf: Herstellen einer Ausnehmung in der elektrischen Komponente zwischen dem ersten Isolationsabschnitt und dem zweiten Isolationsabschnitt.

Die Ausnehmung ist beispielsweise ein Durchbruch in Form eines Schlitzes in der elektrischen Komponente, z.B. in einer mit elektrischen Bauelementen bestückten Leiterplatte, und die Ausnehmung verläuft zwischen den beiden Isolationsabschnitten bzw. zwischen den darunter angeordneten elektrischen Bauelementen, um die Kriechstromfestigkeit zu erhöhen.

Gemäß der Erfindung wird eine Mehrzahl von übereinanderliegenden Schichten Isoliermaterial in Form eines geschlossenen Polygonzugs bestehend aus einem ersten Isoliermaterial auf der elektrischen Komponente aufgebracht, so dass der geschlossene Polygonzug einen Teil einer Oberfläche der elektrischen Komponente und ein hierauf angeordnetes elektrisches Bauelement umschließt. Das Verfahren weist weiterhin den Schritt auf: Applizieren eines zweiten Isoliermaterials auf die von dem geschlossenen Polygonzug umschlossene Oberfläche der elektrischen Komponente.

Das erste Isoliermaterial wird als sich senkrecht zu der elektrischen Komponente erstreckende Wand auf eine Oberfläche der elektrischen Komponente aufgetragen und verläuft als geschlossener Polygonzug, d.h. dass die Wand aus erstem Isoliermaterial einen Teil der Oberfläche der elektrischen Komponente vollständig umschließt, z.B. einen Teil der Oberfläche, auf dem ein elektrisches Bauelement auf der Leiterplatte angeordnet ist. Das zweite Isoliermaterial wird nach Auftragen des ersten Isoliermaterials auf die von dem geschlossenen Polygonzug umschlossene Fläche auf der elektrischen Komponente aufgetragen.

Diese Schritte ermöglichen es, einen Ausdehnungsbereich des zweiten Isoliermaterials auf der Oberfläche der elektrischen Komponente einzugrenzen, nämlich durch den geschlossenen Polygonzug bestehend aus erstem Isoliermaterial.

Gemäß einer weiteren Ausführungsform der Erfindung weist das zweite Isoliermaterial beim Applizieren auf die elektrische Komponente eine niedrigere Viskosität auf als das erste Isoliermaterial.

Viskosität betrifft in diesem Zusammenhang die Viskosität beim Aufbringen des ersten Isoliermaterials und des zweiten Isoliermaterials. Das zweite Isoliermaterial kann insbesondere eine so geringe Viskosität aufweisen, dass es in Leerräume unterhalb einer elektrischen Komponente fließt und nicht an der Stelle der Oberfläche der elektrischen Komponente verbleibt, auf die es aufgetragen wurde. In anderen Worten fließt oder verteilt sich das zweite Isoliermaterial nach dem Applizieren zunächst über die von dem geschlossenen Polygonzug eingegrenzte Oberfläche der elektrischen Komponente. Auch das zweite Isoliermaterial ist ausgeführt, auszuhärten. Die Viskosität des zweiten Isoliermaterials kann verändert werden, indem beispielsweise die Applikationstemperatur des zweiten Isoliermaterials verändert, insbesondere erhöht, wird oder indem ein Isoliermaterial mit niedrigerer Viskosität verwendet wird.

Gemäß einer weiteren Ausführungsform der Erfindung weist das Verfahren weiterhin den Schritt auf: Aufbringen einer elektrisch leitfähigen Schicht auf das Isoliermaterial, so dass sich das Isoliermaterial zwischen der elektrisch leitfähigen Schicht und der elektrischen Komponente befindet.

Die elektrisch leitfähige Schicht kann insbesondere der elektromagnetischen Abschirmung eines elektrischen Bauelements dienen, und zwar der Abschirmung vor äußeren Einflüssen und der Abschirmung benachbarter Bauelementen vor dem mit der elektrisch leitfähigen Schicht versehenen Bauelement. Die elektrisch leitfähige Schicht kann so verlaufen, dass diese elektrisch mit einem Gehäuse der elektrischen Komponente gekoppelt ist.

Gemäß einer weiteren Ausführungsform der Erfindung wird das Verfahren zum Herstellen einer Hochspannungsisolierung von elektrischen Bauteilen verwendet, die für die Nutzung in einem luftleeren Raum in der Erdumlaufbahn vorgesehen sind.

Bei solchen Bauteilen kann es sich beispielsweise um Satellitenkomponenten handeln, z.B. um Wanderfeldröhrenverstärker (travelling wave tube, TWT) oder Teile hiervon. TWTs werden üblicherweise als Leistungsverstärker in Satelliten eingesetzt. Diese bestehen aus einer Wanderfeldröhre, die vornehmlich die Hochfrequenzeigenschaften bestimmt, und einer Stromversorgung, die die Versorgungsspannung, üblicherweise eine Hochspannung, für die TWT erzeugt und die Telemetrie- und Telekommando-Schnittstelle zum Satelliten darstellt. Für die Erzeugung der für den Betrieb notwendigen Hochspannungen werden in Reihe geschaltete Gleichrichterstufen eingesetzt. Diese müssen für den Betrieb in der Raumfahrt gegeneinander und gegen das Gehäuse elektrisch isoliert werden. Eine solche Isolierung wird durch das hierin beschriebene Verfahren ermöglicht.

Da in der Erdumlaufbahn, in der ein Satellit üblicherweise betrieben wird, Vakuum vorliegt, wird die Isolierung üblicherweise lediglich für die Testphase auf der Erde und für die Transportphase benötigt, da im Vakuum grundsätzlich eine Isolierung vorliegt. Das Weglassen von Isoliermaterial bietet damit den Vorteil, dass das Gewicht der elektrischen Komponente reduziert wird, um den Aufwand für den Transport in die Erdumlaufbahn zu reduzieren. Weiterhin wird im Vakuum die Isoliereigenschaft des Isoliermaterials nicht benötigt, da durch das Vakuum eine Isolation bereitgestellt wird. Es kann bei einer Vollummantelung der elektrischen Komponente sogar dazu kommen, dass auf Grund von Alterungserscheinungen des Isoliermaterials die Isolationsleistung geringer wird, was unerwünscht sein kann. Gerade wenn mehrere Isolationsabschnitte für einzelne Bauelemente vorgesehen sind, befindet sich zwischen den Isolationsabschnitten Vakuum, und die Isolation dieser beiden elektrischen Bauelemente voneinander kann sich nicht durch degradiertes Isoliermaterial verschlechtern.

Als Isoliermaterial kann jedes hochspannungstaugliche Material verwendet werden, welches eine elektrische Isolierung bietet. Beispielsweise kann Solithane als Isoliermaterial verwendet werden.

Gemäß der Erfindung erfolgt das Auftragen des Isoliermaterials auf die elektrische Komponente mittels eines 3D-Druckverfahrens.

Dabei wird das Isoliermaterial schichtweise aufgetragen und die laterale Ausdehnung und Form einer jeden Schicht kann einzeln festgelegt und an die Kontur der elektrischen Komponente so angepasst werden, dass die Menge des benötigten Isoliermaterials reduziert wird und die Güte der Isolierung dennoch im Wesentlichen erhalten bleibt.

Im Folgenden werden mit Bezug zu den Zeichnungen Ausführungsbeispiele der Erfindung beschrieben.

### Kurze Beschreibung der Zeichnungen

Fig. 1 zeigt eine schematische Darstellung einer elektrischen Komponente.
Fig. 2 zeigt eine Seitenansicht einer elektrischen Komponente mit aufgetragenem Isoliermaterial mit einem Verfahren gemäß einem Aspekt der Erfindung.
Fig. 3 zeigt eine Draufsicht auf eine elektrische Komponente mit aufgetragenem Isoliermaterial mit einem Verfahren gemäß einem weiteren Aspekt der Erfindung.
Fig. 4 zeigt eine Seitenansicht einer elektrischen Komponente mit aufgetragenem Isoliermaterial mit einem Verfahren gemäß einem Ausführungsbeispiel der Erfindung.
Fig. 5 zeigt eine Draufsicht auf die Darstellung in Fig. 4.
Fig. 6 zeigt eine Seitenansicht einer elektrischen Komponente mit aufgetragenem Isoliermaterial mit einem Verfahren gemäß einem weiteren Aspekt der Erfindung.
Fig. 7 zeigt eine Seitenansicht einer elektrischen Komponente mit aufgetragenem Isoliermaterial und einer elektrisch leitfähigen Beschichtung mit einem Verfahren gemäß einem weiteren Aspekt der Erfindung.

### Detaillierte Beschreibung von Ausführungsbeispielen

Die Darstellungen in den Figuren sind schematisch und nicht maßstabsgetreu. Werden gleiche Bezugszeichen verwendet, so beziehen sich diese auf gleiche oder ähnliche Elemente.

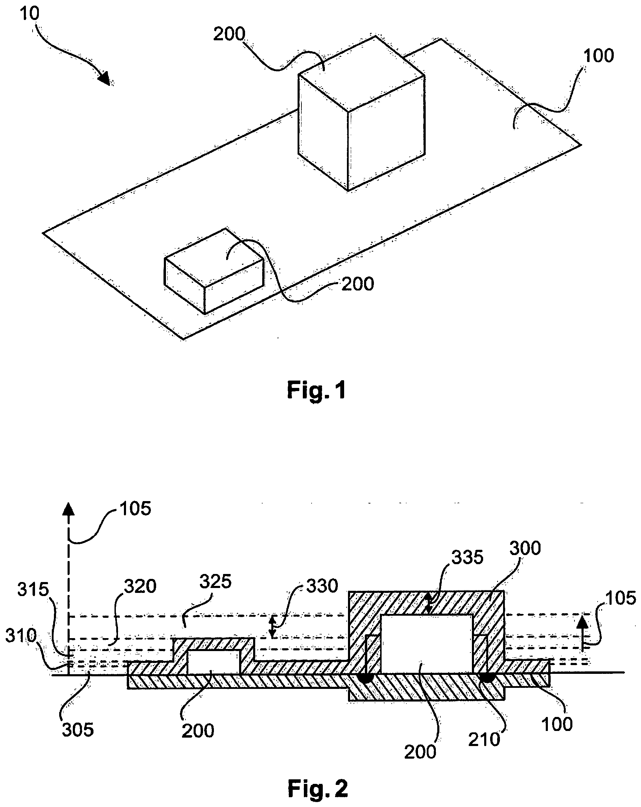

Fig. 1 zeigt eine schematische isometrische Darstellung einer elektrischen Komponente 10 aufweisend ein Trägerelement, z.B. eine Leiterplatte 100, und zwei elektrische Bauelemente 200, welche auf einer Oberfläche des Trägerelements angeordnet sind und mechanisch und elektrisch mit dem Trägerelement gekoppelt sind. Bei den elektrischen Bauelementen 200 kann es sich um einzelne elektrische oder elektronische Bauteile wie z.B. eine Induktivität, eine Kapazität, oder einen integrierten Schaltkreis handeln. Es sei darauf hingewiesen, dass das hierin beschriebene Verfahren mit allen möglichen elektrischen Bauteilen von jedweder geometrischer Form ausgeführt werden kann.

Bei einem herkömmlichen Verfahren zum Vergießen der elektrischen Komponente 10 wird eine Vergussform bereitgestellt, welche im Wesentlichen an die Kontur der elektrischen Komponente 10 angepasst ist. Die elektrische Komponente 10 wird sodann in die Vergussform hinein gelegt und mit einem flüssigen Isoliermaterial ausgegossen. Das Isoliermaterial härtet aus und anschließend wird die vergossene elektrische Komponente aus der Vergussform entnommen. Bei diesem herkömmlichen Verfahren handelt es sich um einen Komplettverguss, welcher als aufwendiger Konturverguss durchgeführt wird.

Im Gegensatz dazu ermöglicht das Verfahren gemäß der Erfindung eine sehr einfache Fertigung und eine gute thermomechanische Anpassung bei gleichzeitig minimaler Menge Isoliermaterial und sehr guter Hochspannungstauglichkeit, welche an die geforderte lange Lebensdauer von beispielsweise 15 bis 20 Jahren bei Satellitenkomponenten. Weiterhin ermöglicht das Verfahren gemäß der Erfindung einen vollständigen Verzicht auf eine Vergussform, so dass auch deren aufwendige Herstellung entfallen kann.

Fig. 2 zeigt eine seitliche Schnittdarstellung einer elektrischen Komponente. Die elektrischen Bauelemente 200 erstrecken sich senkrecht entlang des Pfeils 105 zu einer Oberfläche der Leiterplatte 100. Elektrische Bauelemente 200 können dabei sowohl auf einer Oberseite als auch auf einer Unterseite der Leiterplatte 100 angeordnet sein und über Anschlusselemente 210 elektrisch und/oder mechanisch mit der Leiterplatte 100 gekoppelt sein. Isoliermaterial kann ebenso wie elektrische Bauelemente auf die Oberseite als auch auf die Unterseite der Leiterplatte 100 und dort angeordnete elektrische Bauelemente aufgetragen werden.

Das Isoliermaterial 300 wird in übereinander angeordneten Schichten 305, 310, 315, 320 und 325 aufgetragen. Die Schichten des Isoliermaterials liegen in senkrechter Richtung 105 mit Bezug zu der Leiterplatte 100 übereinander. Die laterale Ausdehnung und Form der Schichten, also die Ausdehnung und Form der Schichten in einer Richtung von links nach rechts in Fig. 2, kann voneinander abweichen. Dadurch kann die Kontur des Isoliermaterials 300 an die Kontur der elektrischen Komponente angepasst werden. Beispielsweise kann die Höhe des Isoliermaterials 300 zwischen den beiden elektrischen Bauelementen 200 geringer sein als die Höhe der elektrischen Bauelemente, um hierdurch die Menge des Isoliermaterials zu reduzieren. Durch das schichtweise Auftragen des Isoliermaterials auf die elektrische Komponente und die Festlegung der lateralen Ausdehnung jeder einzelnen Schicht des Isoliermaterials kann Isoliermaterial im Bereich der elektrischen Bauelemente so aufgetragen werden, wie dies für die Hochspannungsisolierung erforderlich ist und dennoch die Menge des Isoliermaterials so gering wie möglich zu halten.

Die einzelnen Schichten des Isoliermaterials können beispielsweise mit einem Sprühkopf aufgetragen werden, welcher sich parallel zu der Oberfläche der Leiterplatte 100 bewegt. Die Oberfläche der Leiterplatte 100 kann z.B. zeilenweise abgefahren und das Isoliermaterial in diesen Zeilen aufgetragen werden, wobei die Länge und einzelne Abschnitte jeder Zeile festgelegt werden kann. Eine Zeile ist dabei ein Streifen Isoliermaterial, welcher in der Darstellung der Fig. 2 von links nach rechts aufgetragen wird und durchgängig oder unterbrochen sein kann, d.h. dass eine Zeile aus mehreren Abschnitten besteht. Eine Zeile kann eine bestimmte Breite haben, z.B. wenige Zehntel Millimeter bis hin zu wenigen Millimetern. Die Breite einer Zeile entspricht deren Ausdehnung in einer Richtung in die Zeichenebene der Fig. 2 hinein bzw. aus der Zeichenebene heraus.

Eine Schicht des Isoliermaterials kann beispielsweise eine Dicke 330 von wenigen Zehnteln Millimeter aufweisen. Die Dicke des Isoliermaterials auf einem elektrischen Bauelement, also die Höhe 335 des Isoliermaterials, kann zwischen 1/10 Millimeter und mehrere Millimeter betragen, z.B. sechs bis zwölf Millimeter. Auch kann der seitliche Überstand des Isoliermaterials bezogen auf ein elektrisches Bauelement in etwa diesem Maß entsprechen, d.h. dass das Isoliermaterial einen seitlichen oder lateralen Überstand bei einem elektrischen Bauelement zwischen 1/10 Millimeter und mehreren Millimetern, z.B. sechs bis zwölf Millimeter, haben kann.

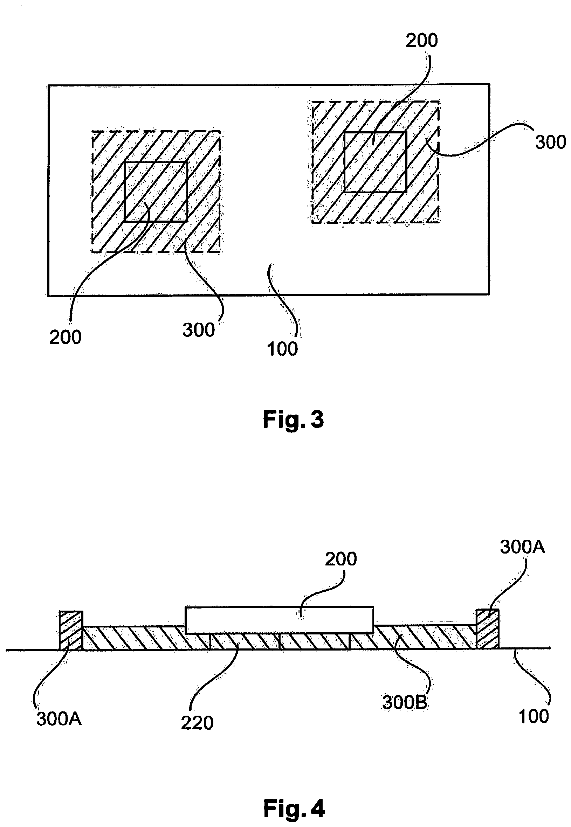

Fig. 3 zeigt eine Draufsicht auf eine elektrische Komponente, wobei zwei Isoliermaterialabschnitte 300 über jeweils eine elektrische Komponente 200 aufgetragen sind. Die beiden Isoliermaterialabschnitte 300 können zeitgleich aufgetragen werden, indem jeweils die Schicht n des ersten Isoliermaterialabschnitts und des zweiten Isoliermaterialabschnitts in einem Schritt aufgetragen werden und anschließend die Schicht n+1 des ersten Isoliermaterialabschnitts und des zweiten Isoliermaterialabschnitts im nächsten Schritt aufgetragen werden. Indem die laterale Ausdehnung und Form jeder einzelnen Schicht des Isoliermaterials bestimmt werden kann, können mit dem Verfahren gemäß der Erfindung voneinander getrennte und beabstandete Isoliermaterialabschnitte auf die elektrische Komponente aufgetragen werden.

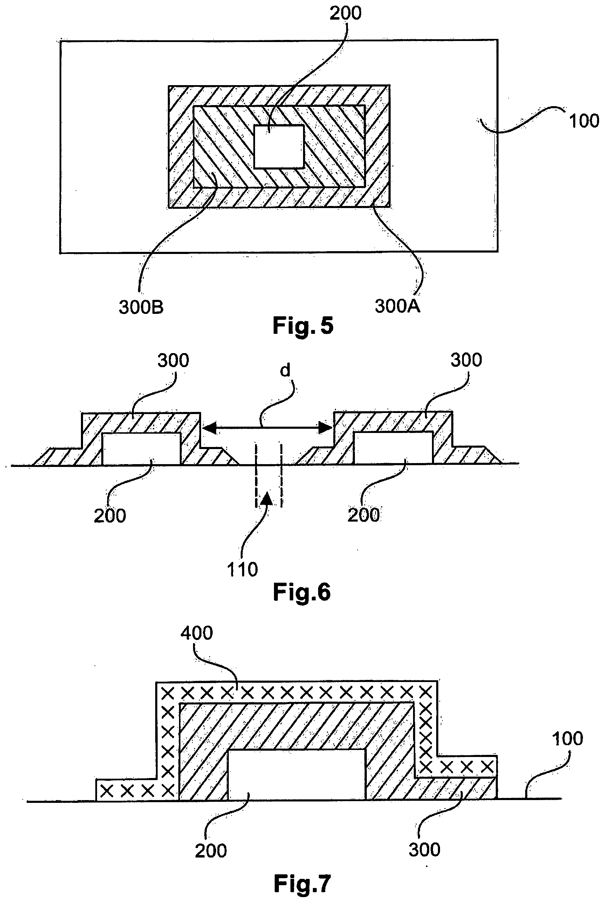

Fig. 4 zeigt eine Seitenansicht einer Schnittdarstellung einer elektrischen Komponente. Fig. 5 zeigt eine Draufsicht auf die Darstellung in Fig. 4 und in der folgenden Beschreibung wird auf beide Figuren Bezug genommen.

Auf die Leiterplatte 100 wird in einem ersten Schritt ein geschlossener Polygonzug aus erstem Isoliermaterial 300A mit einer gewünschten Höhe aufgetragen. Wie in Fig. 5 ersichtlich, stellt der geschlossene Polygonzug ein Rechteck dar, welcher die elektrische Komponente 200 umschließt. Das erste Isoliermaterial 300A kann einen geschlossenen Polygonzug beliebiger Form darstellen, z.B. einen Kreis oder eine andere Form, welche die Funktion erfüllt, die elektrische Komponente zu umschließen, und zwar bevorzugt so, dass der geschlossene Polygonzug einen Abstand >0 mm von dem elektrischen Bauelement 200 aufweist.

In einem anschließenden Schritt wird ein zweites Isoliermaterial 300B auf den von dem geschlossenen Polygonzug 300A umschlossenen Abschnitt der Oberfläche der Leiterplatte 100 aufgetragen. Das zweite Isoliermaterial 300B kann insbesondere eine Beschaffenheit oder Viskosität aufweisen, so dass das zweite Isoliermaterial nach dem Auftragen über die Leiterplatte fließen kann und z.B. in eine Lücke zwischen dem elektrischen Bauelement 200 und der Leiterplatte 100 eindringen kann. Die Lücke kann insbesondere ein Montageabstand 220 sein.

Durch das Auftragen des zweiten Isoliermaterials mit hoher Viskosität beim Auftragen kann insbesondere das Entstehen von Lufteinschlüssen in der Hochspannungsisolierung verhindert werden, da das zweite Isoliermaterial in die Lücke 220 fließt und die Luft verdrängt. Bei dem ersten und zweiten Isoliermaterial kann es sich beispielsweise um thixotropes Material handeln, da beide im flüssigen Zustand aufgetragen werden und nach einer bestimmbaren Zeitspanne aushärten.

Das Auftragen des ersten Isoliermaterials 300A und des zweiten Isoliermaterials 300B kann abwechselnd erfolgen. So kann z.B. nach dem Auftragen des zweiten Isoliermaterials 300B der geschlossene Polygonzug erhöht werden, indem erneut erstes Isoliermaterial auf den bestehenden Polygonzug aufgetragen wird. Anschließend kann dann eine weitere Menge des zweiten Isoliermaterials 300B aufgetragen werden.

Fig. 6 zeigt eine Leiterplatte 100 mit zwei elektrischen Bauelementen 200. Beide Bauelemente 200 sind in Isoliermaterial 300 eingehüllt, so dass sich hier zwei Isoliermaterialabschnitte bilden. Zwischen den beiden Isoliermaterialabschnitten liegt ein Abstand d. Im Orbit, d.h. wenn die elektrische Komponente im Vakuum verwendet wird, befindet sich Vakuum zwischen den Isoliermaterialabschnitten und kann somit die Hochspannungsisolierung verbessern.

Zwischen den Isoliermaterialabschnitten kann eine Ausnehmung 110 in der Leiterplatte 100 angeordnet sein. Die Ausnehmung 110 kann insbesondere ein Schlitz über die gesamte Materialstärke der Leiterplatte 100 sein (hier angedeutet mit den beiden gestrichelten Linien, deren Abstand der Breite des Schlitzes entspricht), um die Kriechstromfestigkeit der elektrischen Komponente zu verbessern.

Fig. 7 zeigt eine Darstellung einer elektrischen Komponente, wobei eine elektrisch leitfähige Schicht 400 über dem Isoliermaterial 300 angeordnet ist. Die elektrisch leitfähige Schicht 400 kann das elektrische Bauelement 200 elektromagnetisch abschirmen und somit die elektromagnetische Verträglichkeit der elektrischen Komponente verbessern. Die elektrisch leitfähige Schicht 400 kann mit der Leiterplatte elektrisch gekoppelt sein.

### Bezugszeichenliste

- 10: elektrische Komponente
- 100: Trägerelement, Leiterplatte
- 105: Orthogonale auf einer Trägerelementebene
- 110: Ausnehmung
- 200: elektrisches Bauelement
- 210: Anschlusselement
- 220: Montageabstand
- 300: Isoliermaterial
- 300A: geschlossener Polygonzug aus erstem Isoliermaterial
- 300B: zweites Isoliermaterial
- 305: erste Schicht
- 310: zweite Schicht
- 315: dritte Schicht
- 320: vierte Schicht
- 325: fünfte Schicht
- 330: Schichtdicke
- 335: Mindestisolierschichtdicke
- 400: elektrisch leitfähige Schicht

## Patentansprüche

1. Verfahren zum Herstellen einer Hochspannungsisolierung von elektrischen Komponenten (10), aufweisend die Schritte
Auftragen einer ersten Schicht (305) Isoliermaterial (300) auf die elektrische Komponente (10);
Auftragen einer zweiten Schicht (310) Isoliermaterial (300) auf die elektrische Komponente;
wobei die zweite Schicht (310) zumindest abschnittsweise auf die erste Schicht (305) aufgetragen wird, so dass die erste Schicht (305) zumindest abschnittsweise zwischen der zweiten Schicht (310) und der elektrischen Komponente (10) angeordnet ist;
**dadurch gekennzeichnet, dass**
das Auftragen des Isoliermaterials auf die elektrische Komponente mittels eines 3D-Druckverfahrens erfolgt;
und, dass das Verfahren weiterhin die Schritte aufweist:
Anbringen einer Mehrzahl von übereinanderliegenden Schichten Isoliermaterial in Form eines geschlossenen Polygonzugs (300A) bestehend aus einem ersten Isoliermaterial auf der elektrischen Komponente, so dass der geschlossene Polygonzug (300A) einen Teil einer Oberfläche der elektrischen Komponente und ein hierauf angeordnetes elektrisches Bauelement (200) umschließt;
Applizieren eines zweiten Isoliermaterials (300B) auf die von dem geschlossenen Polygonzug (300A) umschlossene Oberfläche der elektrischen Komponente.

2. Verfahren nach Anspruch 1, weiterhin aufweisend den Schritt
Auftragen einer n-ten Schicht Isoliermaterial (300) auf die elektrische Komponente;
wobei die n-te Schicht (315) zumindest abschnittsweise auf die (n-1)-te Schicht aufgetragen wird.

3. Verfahren nach Anspruch 2,
wobei der Schritt des Auftragens einer n-ten Schicht Isoliermaterial auf die (n-1)-te Schicht Isoliermaterial so oft wiederholt wird, bis eine vorbestimmte Isoliermaterialdicke (335) auf der elektrischen Komponente (10) erreicht wird.

4. Verfahren nach einem der vorhergehenden Ansprüche,
wobei der Schritt des Auftragens der ersten Schicht (305) Isoliermaterial auf die elektrische Komponente (10) den Teilschritt aufweist:
Applizieren des Isoliermaterials im flüssigen Aggregatzustand auf eine Oberfläche der elektrischen Komponente (10).

5. Verfahren nach Anspruch 4,
wobei nach dem Applizieren des Isoliermaterials der ersten Schicht die zweite Schicht erst aufgetragen wird, wenn das Isoliermaterial der ersten Schicht zumindest teilweise ausgehärtet ist.

6. Verfahren nach einem der vorhergehenden Ansprüche, weiterhin aufweisend die Schritte
Anbringen eines ersten Isolationsabschnitts auf der elektrischen Komponente;
Anbringen eines zweiten Isolationsabschnitts auf der elektrischen Komponente;
wobei der erste Isolationsabschnitt entlang einer Oberfläche der elektrischen Komponente von dem zweiten Isolationsabschnitt beabstandet ist.

7. Verfahren nach Anspruch 6, weiterhin aufweisend den Schritt:
Herstellen einer Ausnehmung in der elektrischen Komponente zwischen dem ersten Isolationsabschnitt und dem zweiten Isolationsabschnitt.

8. Verfahren nach einem der vorhergehenden Ansprüche,
wobei das zweite Isoliermaterial (300B) beim Applizieren auf die elektrische Komponente eine niedrigere Viskosität aufweist als das erste Isoliermaterial.

9. Verfahren nach einem der vorhergehenden Ansprüche, weiterhin aufweisend den Schritt
Aufbringen einer elektrisch leitfähigen Schicht (400) auf das Isoliermaterial (300), so dass sich das Isoliermaterial (300) zwischen der elektrisch leitfähigen Schicht (400) und der elektrischen Komponente (10) befindet.

10. Verfahren nach einem der vorhergehenden Ansprüche,
wobei das Verfahren zum Herstellen einer Hochspannungsisolierung von elektrischen Bauteilen verwendet wird, die für die Nutzung in einem luftleeren Raum in der Erdumlaufbahn vorgesehen sind.

## Claims

1. Method for producing high-voltage insulation of electrical components (10), comprising the steps of
applying a first layer (305) of insulating material (300) to the electrical component (10);
applying a second layer (310) of insulating material (300) to the electrical component;
wherein the second layer (310) is applied at least sectionally to the first layer (305), such that the first layer (305) is arranged at least sectionally between the second layer (310) and the electrical component (10);
**characterized in that**
the insulating material is applied to the electrical component by way of a 3D printing method;
and **in that** the method furthermore comprises the steps of:
applying a multiplicity of overlapping layers of insulating material in the form of a closed traverse (300A) consisting of a first insulating material on the electrical component, such that the closed traverse (300A) encloses part of a surface of the electrical component and an electrical component (200) arranged thereon;
applying a second insulating material (300B) to the surface, enclosed by the closed traverse (300A), of the electrical component.

2. Method according to Claim 1, furthermore comprising the step of
applying an nth layer of insulating material (300) to the electrical component;
wherein the nth layer (315) is applied at least sectionally to the (n-1)th layer.

3. Method according to Claim 2,
wherein the step of applying an nth layer of insulating material to the (n-1)th layer of insulating material is repeated as often as a predetermined insulating material thickness (335) is reached on the electrical component (10).

4. Method according to one of the preceding claims,
wherein the step of applying the first layer (305) of insulating material to the electrical component (10) comprises the substep of:
applying the insulating material to a surface of the electrical component (10) in the liquid aggregate state.

5. Method according to Claim 4,
wherein the second layer is applied after the insulating material of the first layer has been applied only if the insulating material of the first layer has at least partly cured.

6. Method according to one of the preceding claims, furthermore comprising the steps of
applying a first insulation section to the electrical component;
applying a second insulation section to the electrical component;
wherein the first insulation section is spaced from the second insulation section along a surface of the electrical component.

7. Method according to Claim 6, furthermore comprising the step of:
producing a recess in the electrical component between the first insulation section and the second insulation section.

8. Method according to one of the preceding claims,
wherein the second insulating material (300B) when applied to the electrical component has a lower viscosity than the first insulating material.

9. Method according to one of the preceding claims, further having the step of
applying an electrically conductive layer (400) to the insulating material (300) such that the insulating material (300) is located between the electrically conductive layer (400) and the electrical component (10).

10. Method according to one of the preceding claims,
wherein the method for producing high-voltage insulation is used for electrical components that are intended for use in a vacuum in the Earth's orbit.

## Revendications

1. Procédé de fabrication d'une isolation haute tension de composants électriques (10), comprenant les étapes suivantes :
application d'une première couche (305) de matériau isolant (300) sur le composant électrique (10) ;
application d'une deuxième couche (310) de matériau isolant (300) sur le composant électrique ;
dans lequel la deuxième couche (310) est appliquée au moins par sections sur la première couche (305) de manière à ce que la première couche (305) soit disposée au moins par sections entre la deuxième couche (310) et
le composant électrique (10) ;
**caractérisé en ce que**
l'application du matériau isolant sur le composant électrique est réalisée au moyen d'un procédé d'impression en 3D ;
et **en ce que** le procédé comprend en outre les étapes suivantes :
dépôt d'une pluralité de couches superposées de matériau isolant sous la forme d'un tracé polygonal fermé (300A) constitué d'un premier matériau isolant sur le composant électrique, de manière à ce que le tracé polygonal fermé (300A) entoure une partie d'une surface du composant électrique et un composant électrique (200) disposé sur celle-ci ;
application d'un deuxième matériau isolant (300B) sur la surface du composant électrique entouré par le tracé polygonal fermé (300A).

2. Procédé selon la revendication 1, comprenant en outre l'étape suivante :
application d'une n-ième couche de matériau isolant (300) sur le composant électrique ;
dans lequel la n-ième couche (315) est appliquée au moins par sections sur la (n-1)-ième couche.

3. Procédé selon la revendication 2,
dans lequel l'étape d'application d'une n-ième couche de matériau isolant sur la (n-1)-ième couche de matériau isolant est répétée jusqu'à ce qu'une épaisseur prédéterminée de matériau isolant (335) soit obtenue sur le composant électrique (10).

4. Procédé selon l'une des revendications précédentes, dans lequel l'étape d'application de la première couche (305) de matériau isolant sur le composant électrique (10) comprend la sous-étape suivante :
application du matériau isolant à l'état d'agrégat liquide sur une surface du composant électrique (10).

5. Procédé selon la revendication 4,
dans lequel, après l'application du matériau isolant de la première couche, la deuxième couche n'est appliquée que lorsque le matériau isolant de la première couche a au moins partiellement durci.

6. Procédé selon l'une des revendications précédentes, comprenant en outre les étapes suivantes :
dépôt d'une première section d'isolation sur le composant électrique ;
dépôt d'une deuxième section d'isolation sur le composant électrique ;
dans lequel la première section d'isolation est espacée de la deuxième section d'isolation le long d'une surface du composant électrique.

7. Procédé selon la revendication 6, comprenant en outre l'étape suivante :
réalisation d'un évidement dans le composant électrique entre la première section d'isolation et la deuxième section d'isolation.

8. Procédé selon l'une des revendications précédentes, dans lequel le deuxième matériau isolant (300B) présente une viscosité inférieure à celle du premier matériau isolant lorsqu'il est appliqué sur le composant électrique.

9. Procédé selon l'une des revendications précédentes, comprenant en outre l'étape suivante :
application d'une couche électriquement conductrice (400) sur le matériau isolant (300) de manière à ce que le matériau isolant (300) soit situé entre la couche électriquement conductrice (400) et le composant électrique (10).

10. Procédé selon l'une des revendications précédentes, dans lequel le procédé est utilisé pour fabriquer une isolation haute tension de composants électriques destinés à être utilisés dans un espace vide en orbite terrestre.
